Europäisches Patentamt

European Patent Office

Office européen des brevets

(11) Publication number: **0 359 202**
**A1**

## EUROPEAN PATENT APPLICATION

(21) Application number: **89116869.2**

(22) Date of filing: **12.09.89**

(51) Int. Cl.5: **H01L 21/316**

(30) Priority: **13.09.88 JP 229005/88**

(43) Date of publication of application:
**21.03.90 Bulletin 90/12**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Tomisawa, Yutaka Intellectual**
**Property Division**
**K.K. Toshiba 1-1 Shibaura 1-chome**
**Minato-ku Tokyo(JP)**
Inventor: **Mitani, Tatsuro Intellectual Property**
**Division**
**K.K. Toshiba 1-1 Shibaura 1-chome**
**Minato-ku Tokyo(JP)**
Inventor: **Imamura, Souichi Intellectual**
**Property Division**
**K.K. Toshiba 1-1 Shibaura 1-chome**
**Minato-ku Tokyo(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Compound semiconductor device having phosphorus-containing surface protective film and method of fabricating same.

(57) A compound semiconductor device of this invention has first and second surface protective films (24, 26) on active region layers (14, 16a, 16b) of a predetermined conductivity type. According to a method of fabricating this compound semiconductor device, active region layer (14) of the predetermined conductivity type, for example, N-type, and $N^+$-type active region layers (16a, 16b) are formed on GaAs substrate (12) having a semi-insulating property, latter layers (16a, 16b) being adjacent to the former layer (14). Gate electrode (18) is formed on N-type active region layer (14) in Schottky contact therewith, and source electrode (20) and drain electrode (22) are formed on $N^+$-type active region layers (16a, 16b) in Ohmic contact therewith. Phosphate-silicate-glass layer (24) containing phosphorus is deposited as a first surface protective film on N-type and $N^+$-type active region layers (14, 16a, 16b) and elec-trodes (18, 20, 22) to protect these active region layers. Silicon dioxide film (26), which does not contain phosphorus, is deposited as a second surface protective film over layer (24) to protect N-type and $N^+$-type active region layers (14, 16a, 16b). Then layer (24) containing phosphorus and layer (26), containing no phosphorus, which are deposited on individual electrodes (18, 20, 22), are removed.

F I G. 1C

# Compound semiconductor device having phosphorus-containing surface protective film and method of fabricating same

The present invention relates to a compound semiconductor device having a compound semiconductor as a substrate material, and, more particularly, to a compound semiconductor device having a surface protective film containing phosphorus and a method for fabricating the same.

Epitaxially-grown crystal is typically used in compound semiconductor devices to thereby form a solid consisting of a combination of different elements of the same group, with an arbitrary composition ratio. A conventional MES (Metal Semiconductor) type FET having a GaAs (gallium-arsenic) substrate material, as disclosed in, for example, "Ultra High-Speed Compound Semiconductor Device," Baifukan, compiled under the supervision of Takuo Kanno and edited by Masamichi Ohmori, pages 74-76, is fabricated as follows. Formed in a GaAs substrate are an N-type active region layer and an $N^+$-type active region layer, and on this N-type active region layer is a gate electrode formed by, for example, W (tungsten) that can make a Schottky contact therewith. In addition, source and drain electrodes are formed on the $N^+$-type active region layer by, for example, AuGe (gold-germanium) that can form an Ohmic contact therewith. A surface protective film is deposited on the surfaces of these active region layers, and a contact hole is formed in each electrode.

In the conventional compound semiconductor devices, a silicon oxide film, silicon nitride film, silicon oxide nitride film, aluminum nitride film, a polyimide film and a laminate film, formed by a combination of the former films, are mainly used as surface protective films.

The use of a surface protective film in semiconductor devices generally arises from the necessity to:

  (1)  Protect the semiconductor surface against external contaminants.

  (2)  Protect the semiconductor surface against external physical and mechanical damage.

  (3) Stabilize the electric (electronic) instability of the semiconductor surface.

The above prior art can satisfy the first two requirements (1) and (2), but cannot fulfill the last requirement (3). Although there are many causes for the electric (electronic) instability mentioned in (3), such as problems originating from ion bonding, what matters here is the difference in the thermal expansion coefficient between the semiconductor material and the surface protective film. In other words, stress is generated in the semiconductor surface due to the difference in the thermal expansion coefficient between the semiconductor material and surface protective film, and this stress causes electronic instability.

For instance, Si (silicon), a typical semiconductor substrate material, has a thermal expansion coefficient of $2.6 \times 10^{-6}\,°C^{-1}$, while GaAs has $5.9 \times 10^{-6}\,°C^{-1}$ and other compound semiconductors have, like GaAs, nearly twice as large a thermal expansion coefficient as Si. In contrast, a silicon dioxide ($SiO_2$) film, a typical surface protective film, has a general value of $5 \times 10^{-7}\,°C^{-1}$, which is significantly smaller than that of the substrate material. The aforementioned surface protective film according to the prior art has a thermal expansion coefficient close to that of $SiO_2$, excluding the polyimide film that is of an organic material.

Due to a large difference in the thermal expansion coefficient between the semiconductor substrate material and the surface protective film, therefore, stress is generated therebetween. This stress acts on the functional region formed in the main surface of the semiconductor, thus rendering this functional region electrically (electronically) unstable.

This electric (electronic) instability impairs the characteristic of a semiconductor device. For instance, the high frequency power gain of the aforementioned MES type FET, having GaAs as the substrate material, would significantly deteriorate with time.

Compound semiconductors are apt to be affected by most chemicals, particularly by acidic solutions. If a silicon oxide film containing phosphorus (PSG) is used as the surface protective film of a compound semiconductor in the prior art, therefore, the PSG is likely to absorb water from the atmosphere. As a result, the PSG absorbing water easily produces phosphoric acid (water) which will affect the compound semiconductor itself. This will deteriorate the function of the compound semiconductor, therefore PSG has not been employed as a surface protective film of compound semiconductor devices according to the prior art.

Accordingly, it is an object of this invention to provide a good compound semiconductor device with less characteristic deterioration, and a method for fabricating the same, by reducing the electric (electronic) instability of the surface of the compound semiconductor device which is caused by the stress acting on the semiconductor surface at the time when the surface protective film is deposited thereon.

According to one aspect of the present invention, there is provided a compound semiconductor device comprising:

substrate means having a semi-insulating property;
a first active region layer of a predetermined conductivity type formed on the substrate means;
a second active region layer of the same conductivity type as that of the first active region layer and having a high concentration, formed on the substrate means adjacent to the first active region layer;
a first electrode section formed on the first active region layer in Schottky contact therewith;
a second electrode section formed on the second active region layer in Ohmic contact therewith;
first surface protective film means, formed on the first and second active region layers but excluding the first and second electrode sections, for directly protecting the first and second active region layers, the first surface protective film means having a predetermined concentration of phosphorus; and
second surface protective film means, covering a surface of the first surface protective film means to protect the first and second active region layers, the second surface protective film means having a lower concentration of phosphorus than the first surface protective film means.

According to another aspect of the present invention, there is provided a method of fabricating a compound semiconductor device comprising the steps of:
forming a first active region layer of a predetermined conductivity type and a second active region layer of the same conductivity type as that of the first active region layer and having a high concentration, on a substrate having a semi-insulating property, the second active region layer being adjacent to the first active region layer;
forming a first electrode section on the first active region layer in Schottky contact therewith and a second electrode section on the second active region layer in Ohmic contact therewith;
depositing a first surface protective film on the first and second active region layers and on the first and second electrode sections, for protecting the first and second active region layers, the first surface protective film having a predetermined concentration of phosphorus;
depositing a second surface protective film, covering a surface of the first surface protective film to protect the first and second active region layers, the second surface protective film having a lower concentration of phosphorus than the first surface protective film; and
removing the first and second surface protective films deposited on the first and second electrode sections.

According to yet another aspect of the present invention, there is provided a method of fabricating a compound semiconductor device comprising the steps of:

forming a first active region layer of a predetermined conductivity type and a second active region layer of the same conductivity type as that of the first active region layer and having a high concentration, on a substrate having a semi-insulating property, the second active region layer being adjacent to the first active region layer;
forming a first electrode section on the first active region layer in Schottky contact therewith;
depositing a first surface protective film on the first and second active region layers and on the first electrode section, for protecting the first and second active region layers, the first surface protective film having a predetermined concentration of phosphorus;
removing that portion of the first surface protective film where a second electrode section is to be formed in Ohmic contact with the second active region;
depositing a metal layer on the first surface protective film and that portion of the second active region layer from which the first surface protective film is removed and where the second electrode section is to be formed, thereby forming the second electrode section in Ohmic contact with the second active region layer;
removing the metal layer deposited on the first surface protective film;
depositing a second surface protective film, covering a surface of the first surface protective film to protect the first and second active region layers, the second surface protective film having a lower concentration of phosphorus than the first surface protective film; and
removing the first and second surface protective films deposited on the first and second electrode sections and the second surface protective film deposited on the second electrode section.

These and other features and advantages of the present invention will become more apparent from the following detailed description of exemplary embodiments as illustrated in the accompanying drawings in which:

Figs. 1A through 1C are cross-sectional views illustrating a step-by-step process of fabricating a compound semiconductor device according to one embodiment of this invention;

Figs. 2A through 2G are cross-sectional views illustrating a step-by-step process of fabricating a compound semiconductor device according to another embodiment of this invention; and

Fig. 3 is a graph showing the relationship between time and high frequency current gain in an MES type FET.

Preferred embodiments of this invention will now be described, referring to the accompanying drawings.

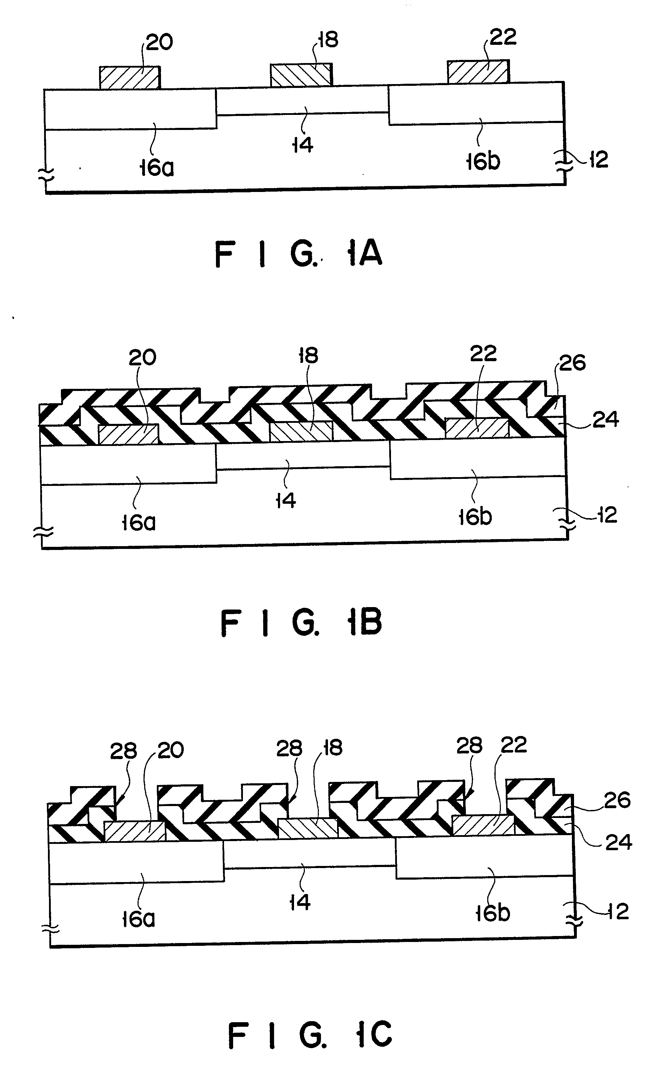

Figs. 1A through 1C illustrate a compound semiconductor device according to one embodiment of this invention and a method of fabricating the same, step by step. An MES type FET having GaAs as its substrate material is illustrated in cross section.

Referring to Fig. 1A, an N-type active region layer 14 and $N^+$-type active region layers 16a and 16b, for example, are formed on a GaAs substrate 12, having a semi-insulating property, by a well-known method. A gate electrode 18 is formed on the N-type active region layer 14 by means of a metal that can form a Schottky contact therewith, such as W (tungsten) having a high melting point. Then, a source electrode 20 and a drain electrode 22 are respectively formed on the $N^+$-type active region layers 16a and 16b by means of a metal that can form an Ohmic contact with these layers 16a and 16b, such as AuGe.

Referring now to Fig. 1B, a PSG (Phosphate-Silicate-Glass) layer 24 containing phosphorus is deposited 3000 Å deep, for example, on the resultant structure as a first surface protective film by a chemical vapor deposition at a temperature of 300 to 350°C, for example. Further, an $SiO_2$ layer 26 containing no phosphorus is deposited 3000 Å deep, for example, on the PSG layer 24 as a second surface protective film, by chemical vapor deposition.

Referring to Fig. 1C, contact holes 28 are formed in the first and second surface protective films 24 and 26 deposited on the individual electrodes 18, 20 and 22, using a photoresist (not shown). This photoresist is then removed and the compound semiconductor device according to the first embodiment is provided.

With the above structure, since the PSG layer 24 containing phosphorus and the $SiO_2$ layer 26 containing no phosphorus, deposited on the former layer 24, serve as two laminated surface protective films, tensile stress caused by the PSG deposition, and compressive stress caused by the $SiO_2$ deposition, can compensate for each other. Accordingly, surface protective films with significantly minimal stress with respect to the semiconductor main surface can be provided, thus improving the stress-originated electric (electronic) instability of the surface of the semiconductor device, and providing a good semiconductor device with less characteristic deterioration.

In addition, since the second surface protective film, the $SiO_2$ layer 26 in this embodiment, which does not allow water to permeate, is deposited on the PSG layer 24 serving as the first surface protective film, it is possible to overcome the conventional problem of the PSG absorbing water from the atmosphere and producing a phosphoric acid, which would affect the compound semiconductor itself and impair its function.

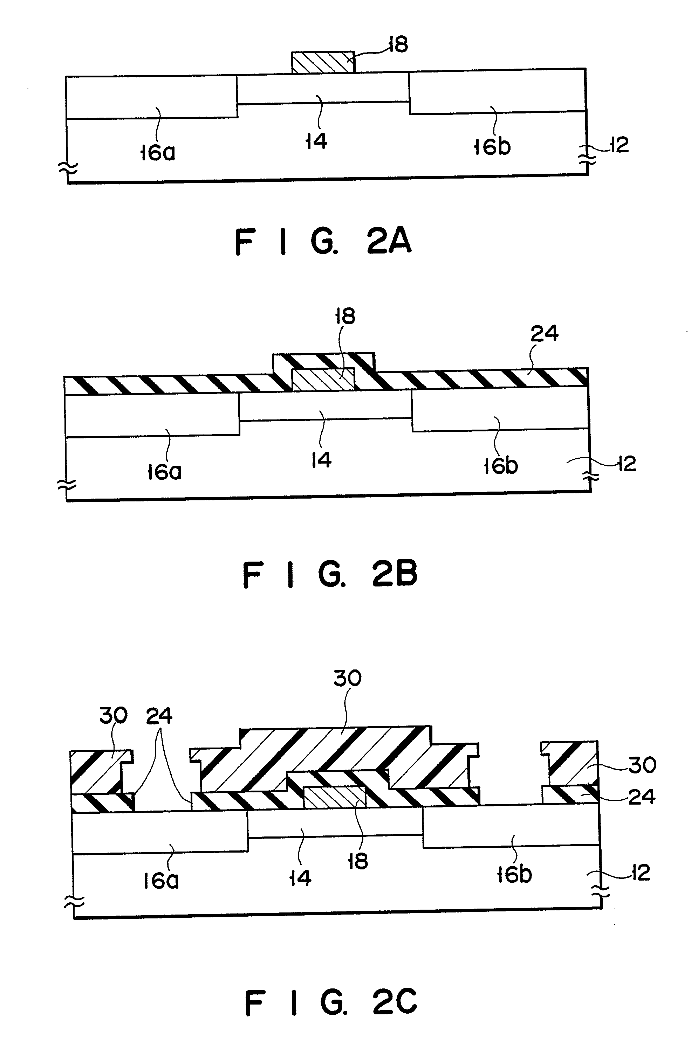

Figs. 2A through 2G illustrate a compound semiconductor device according to a second embodiment of this invention, and a method of fabricating the same step by step; an MES type FET is illustrated in cross section. The same reference numerals as used in the foregoing description of the first embodiment will be used to denote the identical or corresponding elements in the second embodiment, thus omitting their detailed description.

Referring to Fig. 2A, an N-type active region layer 14 and $N^+$-type active region layers 16a and 16b are formed on a GaAs substrate 12, having a semi-insulating property, by a well-known method. A gate electrode 18 is formed on the N-type active region layer 14 by means of a metal that can form a Schottky contact therewith, such as W, having a high melting point.

Referring now to Fig. 2B, a PSG layer 24 serving as a first surface protective film is deposited 3000 Å thick, for example, on the gate electrode 18, N-type active region layer 14, and $N^+$-type active region layers 16a and 16b, by chemical vapor deposition at a temperature of 300 to 350°C, for example.

Referring to Fig. 2C, source and drain electrode patterns are formed using a photoresist 30. After forming each electrode pattern, the PSG layer 24 or the first surface protective film on those regions of the $N^+$-type active region layers 16a and 16b, where the source and drain electrodes are to be formed using the photoresist 30, are removed.

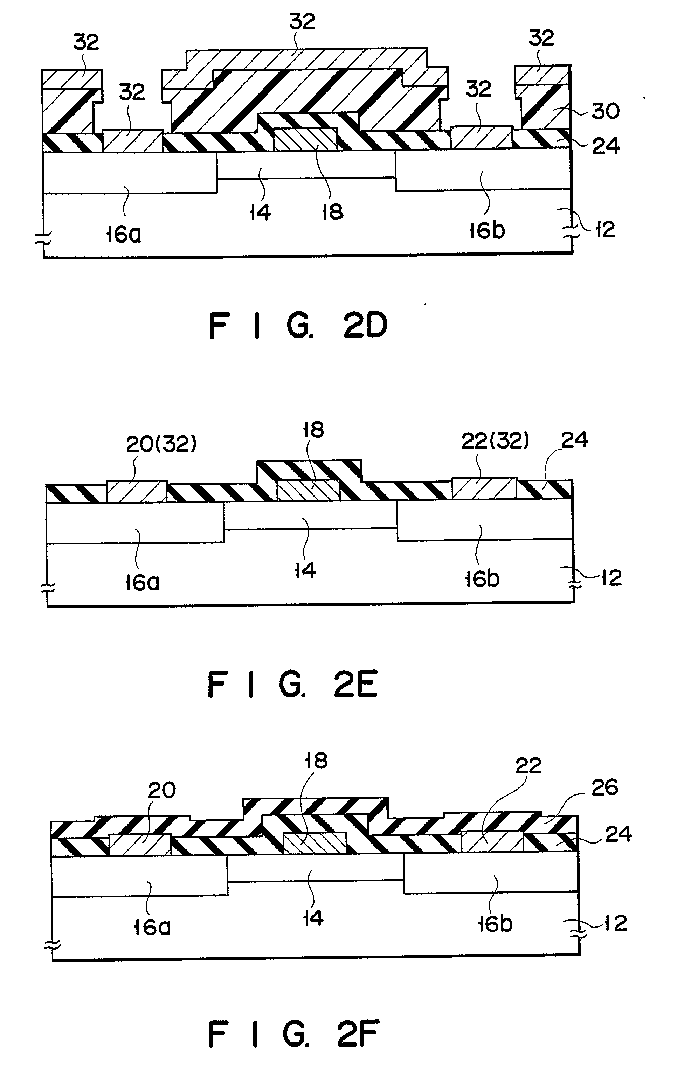

As shown in Fig. 2D, a metal layer 32 of, for example, AuGe, is deposited on the photoresist 30 by a well-known lift-off method. This AuGe metal layer 32 can form an Ohmic contact with the $N^+$-type active region layers 16a, 16b, and those portions of the layer 32 which are deposited on predetermined gaps in the photoresist 30 will serve as a source electrode 20 and a drain electrode 22.

After the AuGe metal layer 32 is deposited on the predetermined positions to serve as the source electrode 20 and drain electrode 22, the photoresist 30 and the AuGe metal layer 32 on the photoresist 30 are both removed as shown in Fig. 2E.

Referring now to Fig. 2F, a $SiO_2$ layer 26 serving as the second surface protective film is deposited 3000 Å thick, for example, on the PSG layer 24 or the first surface protective film, source electrode 20 and drain electrode 22 by chemical vapor deposition at a temperature of 300 to 350°C, for example.

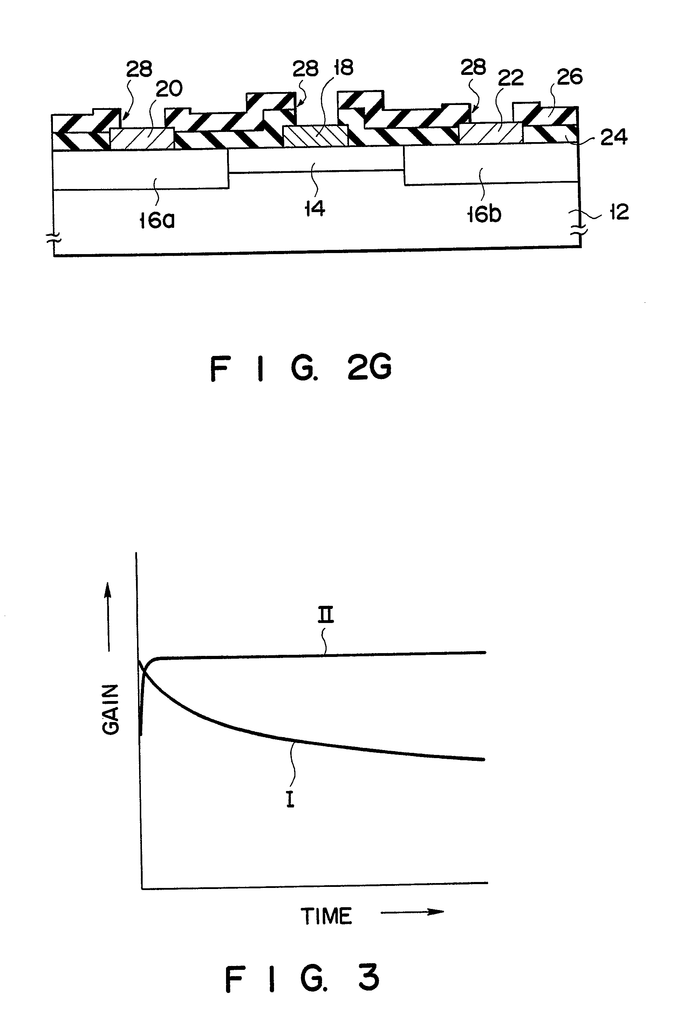

Referring now to Fig. 2G, contact holes 28 are formed in the first and second surface protective films 24 and 26 deposited on the gate electrode 18 and in the second surface protective film 26 deposited on the source electrode 20 and drain electrode 22, using a photoresist (not shown). This photoresist is then removed from the contact holes 28 and the compound semiconductor device according to the second embodiment is provided.

With the above structure, since the PSG layer 24 containing phosphorus and the $SiO_2$ layer 26 containing no phosphorus are laminated on the N-type and $N^+$-type active region layers 14, 16a and 16b, tensile stress caused by the PSG deposition, and compressive stress caused by the $SiO_2$ deposition, can compensate for each other. Accordingly, surface protective films with significantly minimal stress with respect to the semiconductor main surface can be provided, thus improving the stress-originated electric (electronic) instability of the surface of the semiconductor device and providing a good semiconductor device with less characteristic deterioration.

According to the second embodiment, since the source electrode 20 and drain electrode 22 are formed after the formation of the PSG layer 24, the integration density of the semiconductor device around these electrodes is improved.

In addition, since the second surface protective film, the $SiO_2$ layer 26 in this embodiment, which does not allow water permeation, is deposited on the PSG layer 24 serving as the first surface protective film, it is possible to overcome the conventional problem of the PSG absorbing water from the atmosphere and producing a phosphoric acid, which would affect the compound semiconductor itself and impair its function.

According to the above-described first and second embodiments, although the forming of the first and second surface protective films would cause a difference in stress depending on the method (or apparatus) for forming the films, or the conditions under which the films are formed, the optimal method and conditions should be found to minimize the total stress on these two films. Therefore, the methods and conditions are not restricted to those described above. Due to the high vaporization pressure of the compound semiconductor material, however, materials for forming the elements of the semiconductor device may be vaporized depending on the temperature at which the first and second surface protective films are formed, so this temperature should be under 350°C, preferably 300 to 350°C as described earlier.

Fig. 3 is a graph illustrating the relationship between time and high frequency current gain in an MES type FET in the compound semiconductor devices according to these embodiments. The curve I shows the change in high frequency power gain of the conventional fundamental GaAs-MES type FET with time, while the curve II shows the change with time in high frequency power gain in the GaAs-MES type FET embodying this invention.

It should be noted that the conventional curve I shows the gain gradually deteriorating with time and stabilizing at a value deviating significantly from the initial gain during predetermined elapsed time. The curve II of the present invention, by contrast, shows a substantially stable gain characteristic. From this, it should be understood that the gain of the present semiconductor device exhibits less characteristic deterioration over a period of time.

Further, a PSG film which has not been used in a compound semiconductor device in the prior art due to the possibility of its being affected by an acidic solution, can be employed as a surface protective film of a compound semiconductor device by depositing the second protective film which does not allow water to permeate to the PSG layer, thereby preventing the PSG layer from absorbing water from the atmosphere.

In the process of fabricating the compound semiconductor device, chemical vapor deposition and plasma chemical vapor deposition are used to form the surface protective films. The silicon oxide film and the silicon nitride film deposited on a GaAs layer by the latter plasma chemical vapor deposition supply compressive stresses of 3-5 × $10^{10}$ dyne·$cm^{-2}$ and 7-8 × $10^{12}$ dyne·$cm^{-2}$, respectively, and the silicon oxide film deposited by the former vapor deposition compressive stress of 3-9 × $10^{10}$ dyne·$cm^{-2}$. In contrast, it was found that the PSG layer constituted by a silicon oxide film containing phosphorus supplied a tensile stress of 2-5 × $10^{10}$ dyne·$cm^{-2}$. Based on this, if a PSG film is adhered to the surface of a GaAs film and a silicon dioxide film is further deposited on the PSG film, the tensile stress and the compressive stress would compensate for each other, thus providing surface protective films with significantly minimal stress. This can reduce the electric (electronic) instability in the function regions formed in the main surface of the semiconductor device, so that the resultant semiconductor device will have less characteristic deterioration.

Reference signs in the claims are intended for better understanding and shall not limit the scope.

## Claims

1. A compound semiconductor device comprising substrate means having a semi-insulating property, a first active region layer of a predetermined conductivity type formed on said substrate means, a second active region layer of the same conductivity type as that of said first active region layer and having a high concentration, formed on said substrate means adjacent to said first active region layer, a first electrode section formed on said first active region layer in a Schottky contact therewith, a second electrode section formed on said second active region layer in an Ohmic contact therewith, and surface protective film means formed on said first and second active region layers but excluding on said first and second electrode sections, for protecting said first and second active region layers, characterized in that said surface protective film means comprises:

first surface protective film means (24), formed on said first and second active region layers (14, 16a, 16b) but excluding on said first and second electrode sections (18, 20, 22), for directly protecting said first and second active region layers (14, 16a, 16b), said first surface protective film means (24) having a predetermined concentration of phosphorus; and

second surface protective film means (26), covering a surface of said first surface protective film means (24) to protect said first and second active region layers (14, 16a, 16b), said second surface protective film means (26) having a lower concentration of phosphorus than said first surface protective film means (24).

2. A device according to claim 1, characterized in that said first surface protective film means (24) is constituted by a silicon oxide film having a predetermined concentration of phosphorus and said second surface protective film means (26) is constituted by a silicon oxide film containing no phosphorus.

3. A method of fabricating a compound semiconductor device comprising the steps of forming a first active region layer of a predetermined conductivity type and a second active region layer of the same conductivity type as that of said first active region layer and having a high concentration, on a substrate having a semi-insulating property, said second active region layer being adjacent to said first active region layer, forming a first electrode section on said first active region layer in a Schottky contact therewith and a second electrode section on said second active region layer in an Ohmic contact therewith, depositing a surface protective film on said first and second active region layers and said first and second electrode sections to protect said first and second active region layers, and removing said surface protective film deposited on said first and second electrode sections, characterized in that said step of depositing said surface protective film comprises the steps of:

depositing a first surface protective film (24) on said first and second active region layers (14, 16a, 16b) and on said first and second electrode sections (18, 20, 22), for protecting said first and second active region layers (14, 16a, 16b), said first surface protective film (24) having a predetermined concentration of phosphorus; and

depositing a second surface protective film (26), covering a surface of said first surface protective film (24) to protect said first and second active region layers (14, 16a, 16b), said second surface protective film (26) having a lower concentration of phosphorus than said first surface protective film (24).

4. A method according to claim 3, characterized in that said step of depositing said first and second surface protective films (24, 26) is carried out at a temperature of 350°C or lower.

5. A method according to claim 4, characterized in that said step of depositing said first and second surface protective films (24, 26) is carried out at a temperature of 300 to 350°C.

6. A method according to claim 3, characterized in that said first surface protective film (24) is constituted by a silicon oxide film having a predetermined concentration of phosphorus and said second surface protective film (26) is constituted by a silicon oxide film containing no phosphorus.

7. A method of fabricating a compound semiconductor device comprising the steps of forming a first active region layer of a predetermined conductivity type and a second active region layer of the same conductivity type as that of said first active region layer and having a high concentration, on a substrate having a semi-insulating property, said second active region layer being adjacent to said first active region layer, forming a first electrode section on said first active region layer in a Schottky contact therewith, depositing a surface protective film on said first and second active region layers and on said first electrode section, for protecting said first and second active region layers, removing that portion of said surface protective film where a second electrode section is to be formed in Ohmic contact with said second active region, depositing a metal layer on said surface protective film and that portion of said second active region layer from which said surface protective film is removed and where said second electrode section is to be formed, thereby forming said second electrode section in an Ohmic contact with said second active region layer, removing said metal layer deposited on said surface protective film, and removing said surface protective film deposited on said first electrode section, characterized in that said step of depositing said surface protective film comprises depositing a first surface protective film (24) on said first and second active region layers (14, 16a, 16b) and on said first electrode section (18), for protecting said first and second active region layers (14, 16a, 16b), said first surface protective film (24) having a predetermined concentration of phosphorus, and depositing a second surface protective film (26), covering a surface of said first surface protective film (24) to protect said first and second active region layers (14, 16a, 16b), said second surface protective film (26) having a lower concentration of phosphorus than said first surface protective film (24);

that said step of removing that portion of said surface protective film where said second electrode section (20, 22) is to be formed removes said first surface protective film (24); and

that said step of removing said surface protective film deposited on said first electrode section (18) removes said first and second surface protective films (24, 26) deposited on said first electrode section (18) and removes said second surface protective film (26) deposited on said second electrode section (20, 22).

8. A method according to claim 7, characterized in that said step of depositing said first and second surface protective films (24, 26) is carried out at a temperature of $350^{\circ}$ C or lower.

9. A method according to claim 8, characterized in that said step of depositing said first and second surface protective films (24, 26) is carried out at a temperature of 300 to $350^{\circ}$ C.

10. A method according to claim 7, characterized in that said first surface protective film (24) is constituted by a silicon oxide film having a predetermined concentration of phosphorus and said second surface protective film (26) is constituted by a silicon oxide film containing no phosphorus.

F I G. 1A

F I G. 1B

F I G. 1C

F I G. 2A

F I G. 2B

F I G. 2C

F I G. 2D

F I G. 2E

F I G. 2F

28  28  18  28  22  26
20  24

16a  14  16b  12

F I G. 2G

II

GAIN

I

TIME

F I G. 3

# EUROPEAN SEARCH REPORT

European Patent Office

**Application Number**

EP 89 11 6869

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | WO-A-8 303 923 (WESTERN ELECTRIC CO.) * Page 4, line 14 - page 5, line 27; figure; claims * | 1-3,6,7 ,10 | H 01 L 21/316 |
| A | THIN SOLID FILMS, vol. 146, no. 3, 2nd February 1987, pages 221-231, Elsevier Sequoia, Lausanne, CH; C.W. FARLEY et al.: "Encapsulation and annealing studies of semi-insulating InP" * Page 225; figure 2 * | 4,5,8,9 | |
| A | EP-A-0 132 326 (STAUFFER CHEMICAL CO.) | | |
| A | WO-A-8 702 828 (MOTOROLA) | | |
| A | US-A-4 091 406 (LEWIS) | | |
| A | US-A-3 967 310 (HORIUCHI et al.) | | |

|  |  |  | TECHNICAL FIELDS SEARCHED (Int. Cl.5) |
|---|---|---|---|
|  |  |  | H 01 L |

The present search report has been drawn up for all claims

| Place of search | Date of completion of the search | Examiner |
|---|---|---|
| THE HAGUE | 28-11-1989 | GELEBART Y.C.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)